Europäisches Patentamt

European Patent Office

Office européen des brevets

(11) Veröffentlichungsnummer: **0 218 940**

**A1**

(12) **EUROPÄISCHE PATENTANMELDUNG**

(21) Anmeldenummer: 86112804.9

(22) Anmeldetag: 16.09.86

(51) Int. Cl.⁴: **H03K 19/096**

(30) Priorität: 30.09.85 DE 3534867

(43) Veröffentlichungstag der Anmeldung:
22.04.87 Patentblatt 87/17

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Dielacher, Franz, Dipl.-Ing.**
**Auer von Weisbachstrasse 51**
**A-9500 Villach(AT)**
Erfinder: **Pribyl, Wolfgang**
**Heidenfeldstrasse 21**
**A-9500 Villach(AT)**

(54) Schaltungsanordnung zur Spannungspegelumsetzung.

(57) Die Schaltungsanordnung zur Spannungspegelumsetzung eines logischen Eingangspegels UE in
einen anderen UA, dem gleichen logischen Zustand
entsprechenden Ausgangspegel besitzt durch ihre
Ausbildung in komplementärer Metalloxid-Halbleiterlogik eine geringe Verlustleistung, die im wesentlichen mit dem Takt (T) freigesetzt wird und in den
Logikzuständen selbst vernachlässigbar ist.

EP 0 218 940 A1

## Schaltungsanordnung zur Spannungspegelumsetzung

Die Erfindung betrifft eine Schaltungsanordnung nach dem Oberbegriff des Patentanspruchs 1.

Die Anpassung logischer Schaltungsanordnungen mit verschiedenen Logikfamilien aneinander erfordert Pegelumsetzer, um Fehlfunktionen zu verhindern. Beispielsweise können bipolare Pegel mit TTL-Schaltungen nicht erzeugt werden. Bekannt sind statische Pegelumsetzer, die den Nachteil haben, daß sie beim logischen "Low"-Pegel einen Querstrom ziehen und damit eine Verlustleistung aufweisen. Da eine Reduzierung der Verlustleistung generell und speziell bei hochkomplexen Schaltungsanordnungen notwendig ist, sind Pegelumsetzer mit möglichst geringer Verlustleistung wünschenswert.

Der Erfindung liegt die Aufgabe zugrunde, eine Schaltungsanordnung zur Spannungspegelumsetzung eines logischen Eingangspegels in einen anderen, dem gleichen logischen Zustand entsprechenden Ausgangspegel anzugeben, die eine möglichst geringe Verlustleistung, insbesondere in den Logikzuständen selbst aufweist.

Diese Aufgabe wird bei einer Schaltungsanordnung der eingangs genannten Art erfindungsgemäß durch die Merkmale des kennzeichnenden Teils des Patentanspruchs 1 gelöst.

Ausgestaltungen des Erfindungsgedankens sind in Unteransprüchen gekennzeichnet.

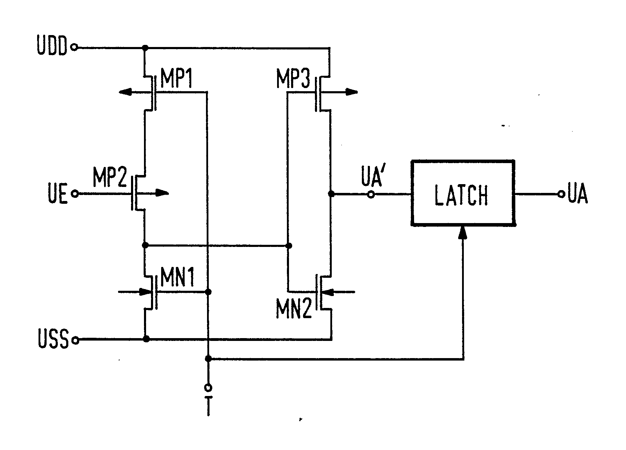

Die Erfindung wird im folgenden anhand eines in der einzigen Figur der Zeichnung dargestellten Ausführungsbeispiels näher erläutert.

Gemäß der Figur enthält die erfindungsgemäße Schaltungsanordnung eine taktgesteuerte Eingangsstufe, eine nachfolgende Inverterstufe sowie ein taktgesteuertes Latch. Die Schaltungsanordnung wird von zwei Polen einer Spannungsversorgungsquelle versorgt, die einen bipolaren Pegel besitzen. So kann beispielsweise die Spannung der Klemme UDD +5 V betragen und die der Klemme USS -5 V. Die Eingangsstufe enthält drei mit ihren Ausgangskreisen in Serie zwischen diese Pole der Versorgungsspannungsquelle geschaltete MOS-Transistoren, von denen die beiden hintereinander liegenden Transistoren MP1 und MP2 vom p-Kanal-Typ und der Transistor MN1 vom n-Kanal-Typ ist. Der Transistor MP2 ist mit seinem Gate an der Eingangsklemme UE angeschlossen, an der der umzusetzende logische Eingangspegel anliegt.

Der Verbindungspunkt der Ausgangskreise der beiden Transistoren MP2 und MN1, das heißt die Drainanschlüsse von MP2 und MN1, ist mit dem Steuereingang der nachfolgenden Inverterstufe aus den beiden Transistoren MP3 und MN2 verbunden, die ebenfalls von den beiden Polen UDD und USS der Spannungsquelle versorgt werden. Die Gates der Transistoren MP3 und MN2 sind miteinander verbunden und der Verbindungspunkt der Ausgangskreise der beiden Transistoren bildet den Ausgang der Inverterstufe, der dem Eingang des nachfolgenden Latch entspricht. Am Ausgang der Inverterstufe liegt ein Spannungspegel UA an, der jedoch noch nicht dem geforderten logischen Ausgangspegel entspricht.

Die Gates der beiden Transistoren MP1 und MN1 sowie der Steuereingang des Latch sind mit einer Klemme T, an dem der Takt an liegt, verbunden. Besitzt der Takteingang hohes Potential, dann sperrt der Transistor MP1 und der Transistor MN1 leitet. Damit befindet sich unabhängig vom logischen Zustand der Eingangsklemme UE der Eingang der Inverterstufe auf einem niedrigen Potential und ihr Ausgangspegel an der Klemme UA auf hohem Potential. Das taktgesteuerte Latch übernimmt nun die Aufgabe, den an seinem Ausgang UA anliegenden logischen Ausgangspegel während des positiven Taktzyklus festzuhalten und den Ausgangspegel der Klemme UA' abzublocken.

Beim negativen Taktzyklus sperrt der Transistor MN1 und der Transistor MP1 leitet. Abhängig vom Schaltzustand des Transistors MP2, dessen Ausgangskreis in Serie zum Ausgangskreis des Transistors MP1 liegt, befindet sich der Eingang der nachfolgenden Inverterstufe damit auf hohem oder niedrigem Potential. Die Inverterstufe schaltet dabei entweder die positive Spannung UDD oder die negative Spannung USS auf die Ausgangsklemme UA . Besitzt die Eingangsklemme UE beispielsweise Nullpotential, dann leitet der Transistor MP2 und am Eingang der Inverterstufe mit den Transistoren MP3 und MN2 liegt ein hohes Potential und somit an der Ausgangsklemme UA das negative Potential USS. Befindet sich das Potential der Eingangsklemme UE auf hohem Potential, dann sperrt der Transistor MP2 und der Eingang der Inverterstufe liegt auf niedrigem Potential, so daß die Ausgangsklemme UA das positive Potential UDD aufweist. In diesen Fällen wird jeweils das Potential der Klemme UA am Eingang des Latch auch an seiner Ausgangsklemme UA übernommen.

Durch den Aufbau der Eingangsstufe und der Inverterstufe mit komplementären Metalloxid-Transistoren fließt ein nicht vernachlässigbarer Querstrom zwischen den beiden Polen UDD und USS der Versorgungsspannungsquelle nur in den Augenblicken, in denen die Transistoren MP1 und MN1 bzw. MP3 und MN2 ihren Schaltzustand ändern, wobei bei den taktgesteuerten Transistoren MP1 und MN1 zusätzlich noch der Steuertransistor MP2 leitend sein muß. Die Verlustleistung dieser dynamischen Schaltungsanordnung zur Spannungspegelumsetzung ist deshalb gegenüber nicht in komplementärer Metalloxid-Halbleiterlogik aufgebauten Schaltungsanordnungen erheblich geringer. Als Transistoren für die Eingangs-und Inverterstufe eignen sich in CMOS-Halbleiterlogik geschaltete Metalloxid-Transistoren vom n-und p-Kanal-Typ.

**Ansprüche**

1. Schaltungsanordnung zur Spannungspegelumsetzung eines an einer Eingangsklemme (UE) liegenden logischen Eingangspegels in einen an einer Ausgangsklemme (UA) liegenden anderen, dem gleichen logischen Zustand entsprechenden logischen Ausgangspegel, **gekennzeichnet** durch eine taktgesteuerte Eingangsstufe (MP1, MP2, MN1), eine nachgeschaltete Inverterstufe (MP3, MN2) sowie ein nachgeschaltetes taktgesteuertes Latch (LATCH).

2. Schaltungsanordnung nach Anspruch 1, **dadurch gekennzeichnet,** daß die Eingangsstufe drei mit ihren Ausgangskreisen in Serie geschaltete Transistoren (MP1, MP2, MN1) enthält, von denen zwei hintereinander liegende vom einen (MP1, MP2) und der dritte (MN1) vom anderen Typ sind, der mittlere (MP2) mit seinem Steuereingang an der Eingangsklemme (UE) und mit einem Ausgangsanschluß am Steuereingang der nachfolgenden Inverterstufe (MP3, MN2) angeschlossen ist und die Gateanschlüsse der beiden äußeren Komplementärtransistoren (MP1, MN1) mit einem Takteingang (T) verbunden sind.

3. Schaltungsanordnung nach Anspruch 1 oder 2, **dadurch gekennzeichnet,** daß der Ausgang -(UA) der Inverterstufe (MP3, MN2) mit dem Eingang des taktgesteuerten Latch (LATCH) und dessen Ausgang mit der Ausgangsklemme (UA) verbunden ist.

4. Schaltungsanordnung nach Anspruch 1 bis 3, **gekennzeichnet** durch die Ausbildung in komplementärer Metalloxid-Halbleiterlogik.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | PATENTS ABSTRACTS OF JAPAN, Band 7, Nr. 280 (E-216)[1425], 14. Dezember 1983; & JP-A-58 157 224 (TOKYO SHIBAURA DENKI K.K.) 19-09-1983 * Figur * | 1-4 | H 03 K 19/096 |
| Y | PATENTS ABSTRACTS OF JAPAN, Band 3, nr. 90 (E-127), 31. Juli 1979; & JP-A-54 69 040 (SHARP K.K.) 02-06-1979 * Figur, Seite E-127 * | 1-4 | |
| Y | US-A-4 401 903 (IIZUKA) * Figur 1; Spalte 1, Zeilen 1-33 * | 1-4 | |
| Y | PATENTS ABSTRACTS OF JAPAN, Band 8, Nr. 84 (E-239)[1521], 18. April 1984; & JP-A-59 4328 (FUJITSU K.K.) 11-01-1984 * Figur * | 1-4 | RECHERCHIERTE SACHGEBIETE (Int. Cl.4)<br><br>H 03 K |
| A | PATENTS ABSTRACTS OF JAPAN, Band 8, Nr. 25 (E-225)[1462], 2. Februar 1984; & JP-A-58 186 227 (TOKYO SHIBAURA DENKI K.K.) 31-10-1983 * Figur * | 1-4 | |

--- -/-

Der vorliegende Recherchenbericht wurde für alle Patentansprüche erstellt.

| Recherchenort | Abschlußdatum der Recherche | Prüfer |
|---|---|---|
| DEN HAAG | 22-12-1986 | FEUER F.S. |

# EUROPÄISCHER RECHERCHENBERICHT

**Europäisches Patentamt**

Nummer der Anmeldung

EP 86 11 2804

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| E | WO-A-8 504 539 (AMERICAN TELEPHONE & TELEGRAPH)<br>* Figur 4; Seite 10, Zeile 18 – Seite 11, Zeile 14 *<br><br>----- | 1-4 | |
| | | | **RECHERCHIERTE SACHGEBIETE (Int. Cl.4)** |

Der vorliegende Recherchenbericht wurde für alle Patentansprüche erstellt.

| Recherchenort | Abschlußdatum der Recherche | Prüfer |
|---|---|---|
| DEN HAAG | 22-12-1986 | FEUER F.S. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82